# EUROPEAN PATENT APPLICATION

(11) **EP 4 648 599 A1**
(43) Date of publication of application: **12.11.2025**
(21) Application number: 24382516.3
(22) Date of filing: 10.05.2024
(51) Int. Cl.: H10N 60/10, H10N 60/12

(54) **SUPERCONDUCTING SYSTEM**

(71) Applicant: ASOCIACIÓN CENTRO DE INVESTIGACIÓN COOPERATIVA EN NANOCIENCIAS "CIC nanoGUNE", 20018 San Sebastian, Guipuzcoa (ES)
(72) Inventor: Chico, Jose Ignacio Pascual, 20018 Donostia/San Sebastián (ES); Trivini, Stefano, 20018 Donostia/San Sebastián (ES); Andres, Jon Ortuzar, 20018 Donostia/San Sebastián (ES)
(74) Representative: Sonnenberg Harrison Partnerschaft mbB

(57) **Abstract**

A nanoscopic superconducting system exhibiting a directional dc current of Cooper pairs that can be controlled with electrostatic gating and can be utilized as superconducting diode, radiation detector, or source of dissipation-less Cooper pair current.

## Description

### TECHNICAL FIELD

The present invention relates to superconducting circuit technology. More precisely, the present invention relates to a superconducting system, a diode having such a superconducting system, a generator of dc Cooper pairs having such a superconducting system, a detector having such a superconducting system, as well as a method of generating directional Cooper pair current.

### PRIOR ART

In current superconducting circuit technology, devices such as superconducting quantum interference devices (SQUIDs), Cooper pair boxes or parametric amplifiers are parts of prior art technology used in quantum sensors, detectors, and qubits.

In a conventional superconductor, the attractive interaction between electrons that produces superconductivity comes from scattering of electrons and phonons. In a first interaction order, the phonon interaction scatters an electron from one momentum state to another momentum state. When taken to a second order, the scattering of a virtual phonon produces a net attractive interaction between two pairs of electrons. The two electrons are attracted, i.e., paired, by the distortion that the two electrons produce in an atomic lattice and this attraction/distortion dominates at low temperatures, at which a transition to a paired state occurs. This is the superconducting state.

The paired electrons do not have to be very close to each other and so their electrostatic repulsive energy, i.e., Coulomb repulsion by two charges of equal sign, is very small compared with the attractive pairing energy.

Cooper pair currents are coherent and dissipation-less currents, the Cooper pairs could travel at zero voltage. Cooper pair currents are used to connect different ones of the superconducting devices.

A Josephson junction is formed by separating two superconducting electrodes with an insulator having a barrier which is thin enough to allow the electrons to tunnel through the barrier. The Josephson current is proportional to the phase difference between the two superconducting electrodes. In a normal Josephson junction, DC Cooper pair current flows in both directions without dissipation and hence without voltage drop, until a critical current is reached, at which point the superconducting state turns into a normal metallic state, i.e., with normal resistance. The Josephson current is produced by the tunnelling interaction.

Josephson junctions show zero dissipation inherent to superconductors.

A superconducting diode has been developed using ferromagnetic layers in a Josephson junction. The ferromagnetic layer in the Josephson junction modifies the critical current in one direction, making it possible that a greater amount of current goes in one direction than in the other direction.

In another example, the DC Cooper pair currents have been produced about a Josephson junction (a so-called SQUID) using an external magnetic field. The external magnetic field also controls the sense of the current. However, the current in the SQUID circulates in a loop and the required external magnetic field might affect the superconductivity.

It is an object of the present invention to provide a superconducting structure capable of generating directional current.

### Summary of the invention

To this effect, the present invention proposes a superconducting system, comprising a nanoscopic element or quantum dot embedded between a first superconducting element and a second superconducting element, to form a first Josephson junction and a second Josephson junction for quantum tunnelling of Cooper pairs through them. The first Josephson junction comprises the first superconducting element and the nanoscopic element or quantum dot, the second Josephson junction comprises the nanoscopic element or quantum dot and the second superconducting element. The nanoscopic element or quantum dot is a superconductor or a non-superconductor with proximitized superconductivity induced by quantum tunnelling of Cooper pairs or by Andreev reflections. The nanoscopic element or quantum dot has a size in a size range in which Coulomb effects start to appear.

In an aspect, the nanoscopic element or quantum dot is smaller than 10000 nm3, in particular is a nanoscopic element with an area smaller than 400 nm2 and a height of less than 20 nm.

With other words, according to the present disclosure, the nanoscopic element or quantum dot is a superconducting island whose superconducting properties are affected by its small size. The nanoscopic element or quantum dot is dimensioned so that Coulomb effects can happen.

In an aspect, the first and second superconducting elements have a mesoscopic or macroscopic dimensions and can therefore function as mesoscopic superconducting electrodes. The first and third superconducting elements have therefore superconducting properties unaffected by their size. For example, it is possible to have first and second superconducting elements that are of the order of few micrometers x hundreds of nanometers.

In an aspect, the first Josephson junction has a first capacitance, the second Josephson junction has a second capacitance, and wherein the capacitances C1, C2 of the two Josephson junctions are typically less than 1 femtofarad.

In an aspect, the system is adapted to generate two Josephson peaks separated by an energy spacing of variable width, each Josephson peak representing the quantum tunnelling of Cooper pairs, wherein the variable width of the spacing depends on the size of the nanoscopic element or quantum dot and the capacitance of the junctions. The Cooper pairs are pairs of correlated electrons. Therefore, different critical currents at opposing directions may be generated. The critical currents are also tunable using an electrostatically gateable quantum dot.

The nanoscopic element or quantum dot can be separated from the first and second superconducting elements by a first and second low-conductance layers, the first and second low-conductance layers being weak electronic links, and wherein the variable width of the spacing further depends on the conductance of the first and second low-conductance layers. The first and second low-conductance layers are weak electronic links and can have resistances that are smaller than100kOhm.

It should be noted that a conductance ratio between the first and second low-conductance layers conductances can be adjusted for optimization. The conductance ratio controls the self-gating, changing the symmetries. Depending on the conductance ratio, the system can work at different energies and asymmetries due to the self-gating effect.

In an aspect, an electrostatic gate device is coupled to the nanoscopic element or quantum dot, to modify the electrostatic potential of the nanoscopic element or quantum dot. This allows to modify a spectral position of the two Josephson peaks, hence tuning the critical currents using the electrostatically gateable nanoscopic element or quantum dot.

The present disclosure therefore teaches a nanoscopic superconducting system exhibiting a directional DC current of Cooper pairs that can be controlled with an electrostatic gating. The superconducting system can be utilized as a superconducting diode, radiation detector, or a source of dissipation-less Cooper pair current.

The electrostatic gate device can be a gate electrode coupled to the nanoscopic element or quantum dot, the electrostatic gate device being adapted to apply a gate Voltage to the nanoscopic element or quantum dot, preferably separated from the nanoscopic element or quantum dot by an insulating material.

The present invention also proposes a superconducting diode having a source and drain, comprising a system as described above, wherein the first superconducting element is a current source, and the second layer of superconductor is a drain.

In an aspect, the superconducting diode is tunable, wherein a gate electrode is connected to the nanoelement or quantum dot to tune the behavior of the superconducting diode by changing the electrostatic potential of the quantum dot.

It should be noted that the conductance ratio between conductances also changes the diode effect.

The present invention further proposes a detector having a system as described above for microwave detection, and a generator of dc Cooper pair currents at zero voltage bias applied between source and drain electrodes having such a system.

The present invention further proposes a method of generating directional Cooper pair current, comprising providing such a superconducting system, wherein the nanoscopic element or quantum dot has a size in a size range in which Coulomb effects start to appear.

In an aspect, the method comprises applying an electrostatic potential to the nanoscopic element or quantum dot, to activate, deactivate or reverse the direction of the dc Cooper pair current.

### Detailed Description of the drawings

Other characteristics and advantages of the invention will be more clearly evident upon reading the description of several currently preferred embodiments, provided as examples only, with reference to the attached drawings, wherein:
Figure 1 shows a system having a quantum dot according to one aspect;
Figure 2 is a representation of the electric circuit formed by the system;
Figure 3 shows a performance of the system of Figure 1 under a gated state of the quantum dot;
Figure 4 shows an embodiment of the system in one aspect;
Figure 5 shows the Josephson current spectrum as a function of the bias voltage in a system of Figures 1 and 2 as embodied in Figure 4, for two different gated states of the quantum dot;
Figure 6 shows the derivative of the Josephson current as a function of bias voltage in a system of Figures 1 and 2, as embodied in Figure 4, for two different gated states of the quantum dot, Figure 7 shows the Josephson current spectrum as a function of the bias current in the embodiment of Figure 4, for one of the two different gated states of the quantum dot depicted in Figures 5 and 6;
Figure 8 shows the Josephson current spectrum as a function of bias current in the embodiment of Figure 4, for the other one of the two different gated states of the quantum dot depicted in Figures 5 and 6;
Figure 9 is a battery comprising a system of Figure 1 according to an aspect;
Figure 10 is detector according to an aspect; and
Figure 11 is a method of generating directional current according to an aspect.

### DETAILED DESCRIPTION

In the figures, identical parts are identified using the same reference numbers.

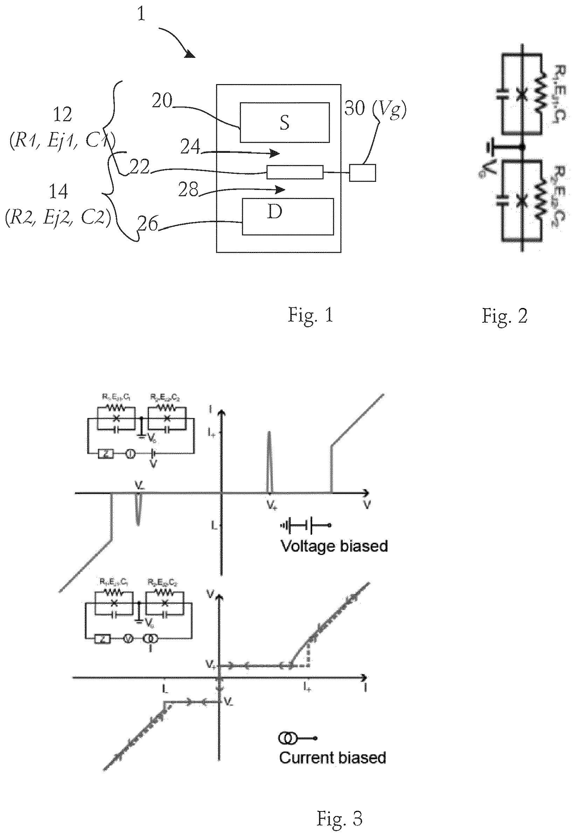

Figure 1 shows a system 1 for generating directional Cooper pair currents according to one aspect of the disclosure.

The system 1 comprises a first Josephson junction 12 and a second Josephson junction 14 for quantum tunnelling of Cooper pairs through them. The first Josephson junction 12 and the second Josephson junction 14 are formed by separating two superconducting electrodes with an insulator thin enough so that electrons can quantum-mechanically tunnel through a barrier.

In the present system 1, the first Josephson junction 12 is made of a first superconducting element 20 and a quantum dot or small superconducting island 22. The first element of superconductor 20 and the quantum dot 22 are separated by a first weak conductance layer 24.

The second Josephson junction is made of the quantum dot 22 and a second element of superconductor 26. The quantum dot 22 and the second element of the superconductor 26 are separated by a second weak conductance layer 28.

Typically, the first weak conductance layer 24 and the second weak conductance layer 28 have low conductance, with resistances that are smaller than 100kOhm. The first weak conductance layer 24 and the second weak conductance layer 28 are electronic weak links.

The first superconducting element 20 and the second superconducting element 26 are mesoscopic or macroscopic superconductors.

The quantum dot 22 is a superconductor or a non-superconductor with proximitized superconductivity induced by quantum tunnelling of Cooper pairs or by Andreev reflections.

In other words, the first Josephson junction 12 and the second Josephson junction 14 have the quantum dot 22 in common and the quantum dot or small superconducting island 22 is sandwiched between the first superconducting element 20 and the third superconducting element26.

The first superconducting element 20 forms a first superconducting electrode. The third superconducting element 26 forms a second superconducting electrode. The second layer of superconductor 22 is embedded between two superconducting electrodes 20, 26. The quantum dot 22 is therefore an island 22 allowing electron dropping between the first superconducting element 20 (acting as a source S), the island 22 and the third superconducting element26 (acting as a drain D).

The quantum dot or small superconducting island 22 is typically smaller than a threshold value amounting to a few tens of nanometers, from 1 to a few tens of nanometers.

The island radius has to be of the nanometer order, from 1 to few tens of nanometers. The dimensions of the island are smaller than typically 400 nm² × 20 nm high, in one aspect smaller than 200 nm² × 3 nm. This means that the volume of the island 22 is of the order of few 10000 nm3 maximum in this disclosure.

With other words, according to the present disclosure, the island has a small size which affects its superconducting properties. The quantum dot or small superconducting island 22 is dimensioned so that Coulomb effects can happen. The quantum dot 22 is therefore in a size range below which Coulomb effects start to appear a nanoscopic superconductor.

The first and third superconducting elements 20, 26 are mesoscopic or microscopic conductors, and function as mesoscopic superconducting electrodes. The first and third superconducting elements 20, 26 have therefore superconducting properties unaffected by their size. For example, it is possible to have first and second superconducting elements 20, 26 that are of the order of few micrometers × hundreds of nanometers.

The pairing energy is the value of the superconducting gap. For the first and third superconducting elements 20, 26, the value of the superconducting gap is the one of the bulk materials they are made of. This is because the first superconducting element 20 and the third superconducting element 26 are mesoscopic or microscopic.

In other words, the quantum dot 22, also referred to the small superconducting island 22, can be made of one superconducting nanoparticle of a very small size L embedded between the two superconducting electrodes formed from the first superconducting element 20 and the third superconducting element 26.

As indicated above, the size of the island 22 must remain below a threshold of typically a few 10 000 nm3. The first superconducting element 20 and the third superconducting element 26 acting as a source and a drain can have any size.

The Coulomb Blockade is the quantum effect that represents the quantization of charge transferred across the Josephson junction. The Coulomb Blockade is caused by enhancement of electrostatic repulsion energy E_{c} due to the small capacitance of the first Josephson junction 12 and of the second Josephson junction 14. The regime of Coulomb Blockade hinders the entrance of current from the first superconducting element 20 into the island 22 until previous electrons leave the island 22 and pass to the third superconducting element 26. Due to the very small size of the island 22, the system 1 enters in the regime of Coulomb Blockade and the Cooper pairs cannot enter unless the Cooper pairs reach a certain value of voltage V.

There is therefore a competing effect between the Josephson current, which is a coherent tunnelling current of Cooper pair (two correlated electrons), and the Coulomb blockade.

The first and third superconducting elements 20 and 26 can be made of any superconducting material and are in one option made from superconductor materials that can be processed by lithography. Examples of such superconductor materials include, but are not limited to aluminum, niobium, and niobium alloys.

The island can be made of any BCS-like superconductor. The island can be made, in one aspect of lead, Pb, Vanadium, V, Niobium, Nb, but this is not limiting the disclosure. It should be noted that the superconductor material has to be able to grow in islands, preferably by lithography.

In another example, the quantum dot 22 is non-superconductor with proximitized superconductivity induced by quantum tunnelling of Cooper pairs or by Andreev reflections.

A gate device 30 can be coupled to the quantum dot or small superconducting island 22. The gate device 30 enables changing an electrostatic potential of said quantum dot or small superconducting island 22.

In one aspect, the gate device 30 is formed by an electrode connected to the quantum dot or small superconducting island 22. The gate device 30 can apply a gate voltage.

The gate device 30 is a voltage injector via electrostatic forces. In other examples the gate device can be a metallic plate, on top of which the island should be created/grown.

The gate electrode 30 is connected to the quantum dot or small superconducting island 22 and is used to apply a gate voltage Vg. The quantum dot or small superconducting island 22 is separated from the gating electrode 30 by a thin insulating barrier. The insulating barrier allows the connection of the gating electrode 30 to the island, yet such that the gating electrode does not increase the size of the island and hence the number of electrons on the island but shift the energy levels according to the applied gate voltage Vg.

The present disclosure therefore teaches to act on the capacitance of the first Josephson junction and on the capacitance of the second Josephson junction to control the regime of Coulomb blockade. The regime of interest here is when the electrostatic repulsion energy E_{c} is comparable to the pairing energy of the superconductors in the first Josephson junction 12 and the second Josephson junction 14. On the quantum dot or small superconducting island 22 between the first layer of the superconductor 20 and the third layer of the superconductor 26, the pairing effect will still dominate, but the insertion of one electron into the quantum dot or small superconducting island 22 results in an extra additional energy given by Coulomb repulsion.

Figure 2 is a representation of an electric circuit formed by the system 1. As illustrated, the electric circuit comprises a double Josephson Junction (EJ1, EJ2) with a parallel resistance (R1, R2) and capacitance (C1, C2) plus the impedance of the circuit out of the Josephson Junctions, Z.

The two Josephson junctions 12, 14 of the system 1 form two capacitors. According to the present disclosure, the capacitances C1, C2 of the two Josephson junctions 12, 13 are given by the size and shape of the first superconducting element 20 acting as a source S and of the third superconducting element 26 acting as a drain D.

The shape of the first and third superconducting elements is the main contributor to the values of the capacitances C1 and C2, The values of the capacitances C1 and C2 are usually similar, as both the drain and the source are similarly shaped.

In one aspect, the capacitance of the first Josephson junction and the capacitance of the second Josephson junction should both be smaller than 1fF.

The modification of the electrostatic potential of the quantum dot or small superconducting island 22 induces an electrostatic asymmetry in the system and favors that the Cooper pair travels in one direction more easily than in the other direction. In other words, the electrostatic gate 30 creates a unidirectional DC current of Cooper pairs.

By varying the gate voltage V_{g}, it is possible to tune the system and even to reverse the direction of the Cooper pair current.

The skilled person understands that by adjusting the value of the gate potential V_{g}, a tunable superconducting diode can be implemented. Instead of using ferromagnetic layers in the Josephson junction to modify the critical current in one direction of the superconducting diode, the present disclosure proposes a double Josephson junction with variable gate of the island, with all layers made of superconducting material. Gating the island allows simply reversing the current flow.

This is illustrated in Figure 3 showing shows a performance of the system of Figure 1 under a gated state of the quantum dot or small superconducting island.

The Coulomb effect results in two Josephson peaks due to the quantum dot or small superconducting island 22. The Josephson current splits into two distinct components. Each Josephson peak represents the quantum tunnelling of Cooper pairs, which are pairs of correlated electrons.

The two Josephson peaks are separated by an energy spacing of variable width, wherein the variable width of the spacing depends on the size of the quantum dot or small superconducting island 22, and the conductance of the weak links 24 and 28 and the capacitance of the junctions 12 and 14.

In the upper part of Figure 3, the electrostatic gate 30 applies a gate voltage V_{g}. This splitting results in two peaks of Cooper pair currents. One of the peaks represents a positive current at positive bias and the other peak represents a reversed current at negative bias.

The separation between the peaks (V+-V- in the figure) is related to electrostatic repulsion energy Ec. When the size of the quantum dot or small superconducting island 22 increases, both of the current peaks in the plot merge to the zero-bias point, which is the standard Josephson current effect observed normally in large superconducting junctions.

In the lower part of Figure 3, the electrostatic gate 30 applies a current bias. As can be seen, a biased Cooper pair current can be produced at a voltage value that depends on current direction up to a critical current IC, which depends on the polarity of the applied current. This demonstrates proof of the superconducting diode, because, in the current regime between I+ and I-, the Cooper pair current only travels in one direction but not in the other direction. The voltage V produced at every polarity also differs.

The width between the two peaks depends on temperature, the circuit and on the capacitances/resistances of the two Josephson junctions.

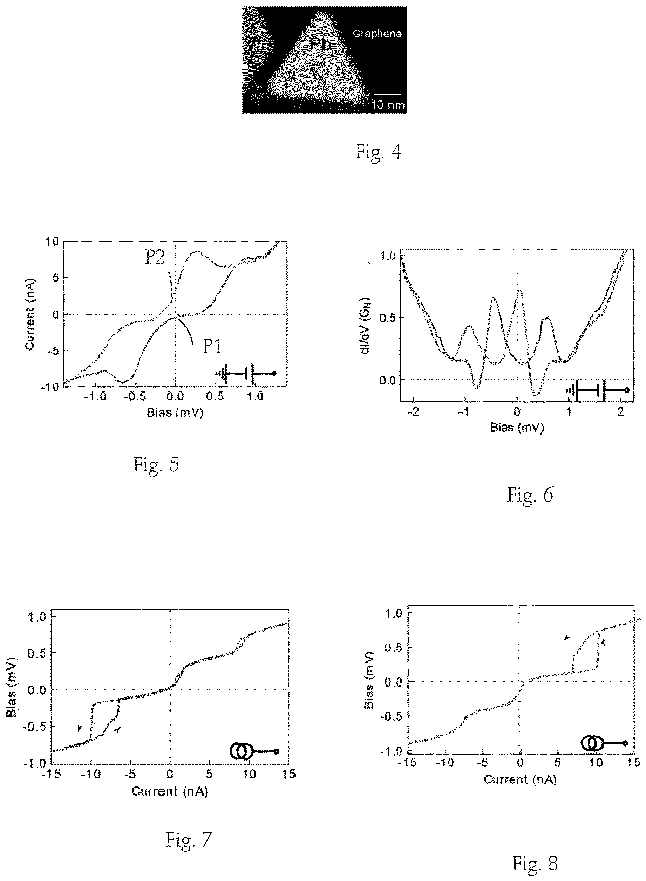

Figure 4 shows an example of the system 1. The system of Figure 4 is an embodiment of a superconducting diode in a low temperature Scanning Tunneling Microscope (STM) at 1.2 K.

The quantum dot or small superconducting island 22 is deposited on a graphene substrate. The graphene is the third superconducting element 26. The graphene turns superconducting by means of the proximity effect and, hence, can function as the drain electrode.

The quantum dot or small superconducting island 22 can be deposited by evaporating a bulk material on the graphene substrate at UHV and 1K. Other methods include lithographic techniques.

The current source is the microscope STM tip, which is covered by Pb and acts as the first superconducting element 20.

In the aspect depicted in Fig 4, the first superconducting element 20 is a layer of lead (Pb), the quantum dot or small superconducting island 22 is made of lead, and the third superconducting element 26 is a substrate layer of graphene.

In the embodiment shown, the first weak conductance layer 24 is vacuum gap, and the contact between the quantum dot or small superconducting island 22 and third superconducting element 26 acts as the second weak conductance layer 28. This is an example only of weak conductance layers 24, 28.

Lead is superconducting at the low temperature at which the measurements are performed, i.e., at a temperature lower than the material's critical temperature. In this non-limiting aspect, the measurements are carried out at 1.2 Kevin (-271.95 Celsius degree).

The quantum dot or small superconducting island 22 is a nanometer size island of lead. In the example, the layer is a nanometer sized layer/island.

Figure 5 shows the Josephson current spectrum as a function of the bias voltage in a system of Figures 1 and 2 as embodied in Figure 4, for two different gated states of the quantum dot, and Figure 6 shows the derivative of the Josephson current as a function of bias voltage in a system of Figures 1 and 2, as embodied in Figure 4, for two different gated states of the quantum dot.

Figures 5 and 6 show two peaks P1, P2 of Josephson current.

As can be seen Figure 5, when no gate voltage is applied, a net current appears. This anomalous current indicates that dc Cooper current is generated with zero gate voltage applied to the island.

Figure 5 shows a current peak at positive gate voltage values (upper graph) and at negative gate voltage values (lower graph), while the current at the corresponding negative (positive) current is much smaller than the current at positive gate voltage values. It is noted that the current measured in this regime corresponds to the Cooper pairs tunneling via the Josephson effect. The system 1, as embodied in the example of Figure 4, is therefore a voltage-biased Josephson diode.

Figure 6 shows the split Josephson peaks in a differential dI/dV spectrum for two different gate voltages of the island 22. The spacing between the peaks amounts to about 1 meV, which is in the order of the pairing energy of the superconductors for lead (1.3 meV), i.e., the pairing energy in the first superconducting element 20 and the island 22. The shift is characterized by Q0/C, where Q0 is a charge value smaller than the electron charge and C is the system's capacitance. The Q0 charge value is about 0.5e, where e is the electron charge.

The pairing energy is the value of the superconducting gap. For the electrodes, i.e., the first and third superconducting elements 20, 26, the value of the superconducting gap is the one of the bulk materials. This is because the first and third superconducting elements 20, 26 are mesoscopic or microscopic, hence big enough. In the aspect of Figure 4, the gate voltage is applied in the form of a pulsed voltage, which can displace the electrostatic levels of the quantum dot or small superconducting island 22 and the superconducting electrodes. The pulses are in one aspect, from -2.5 V to 2.5 V.

It is also possible to control the intensity of the Peaks P1, P2 with the external electrostatic gate voltage V_{g} applied to the quantum dot or small superconducting island 22.

The change in gate changes both the position and the height of the Josephson peaks.

Figure 7 shows the Josephson current spectrum as a function of the bias voltage in the embodiment of Figure 4, for one of the two different gated states of the quantum dot depicted in Figures 5 and 6,

Figure 8 shows the Josephson current spectrum as a function of bias voltage in the embodiment of Figure 4, for the other one of the two different gated states of the quantum dot depicted in Figures 5 and 6.

In Figures 7 and 8, the bias current is injected, and the voltage is measured.

The skilled person knows how to create a current biased source. In a non-limiting example, a current biased system can be obtained with a big resistor, typically around 1MOhm, in series with a voltage source such as a battery. By ensuring that the big resistor is the biggest in the overall system, the resistor plus battery form a current source.

Figures 7 and 8 show the modification of the electrostatic potential of the island by the injection of a bias current (gate current).

The plot in Figure 7 shows a switch from supercurrent to a normal current at - 10 nA (dashed line), while at positive value of current, the switch occurs at 8 nA. The voltage generated at positive current is also larger, and so, more dissipative.

The plot in Figure 8 shows an opposite behavior, where the critical current is 10 nA at positive current bias, but at negative current bias, there is no hysteresis, which means that there is a very small amount of Josephson current.

Therefore, the system 1 can be brought into an asymmetric behavior by small changes in the electrostatic potential of the island. The gate potential induces an electrostatic asymmetry in the system and favors that the Cooper pair current travels in one direction easier than in the other, i.e., paying less voltage V or having a different critical current.

The skilled person understands that the system 1 with first and second superconducting elements 20, 26 forming the electrodes and sandwiching the island 22 can be used as a micro-battery 1040, i.e. as a generator of dc Cooper pair currents. Indeed, at zero gate voltage there is a net anomalous current. This anomalous current indicates that dc Cooper current can be generated with a zero-gate voltage. The origin of the anomalous current at zero bias is related to electromagnetic fluctuations of the environment and by temperature.

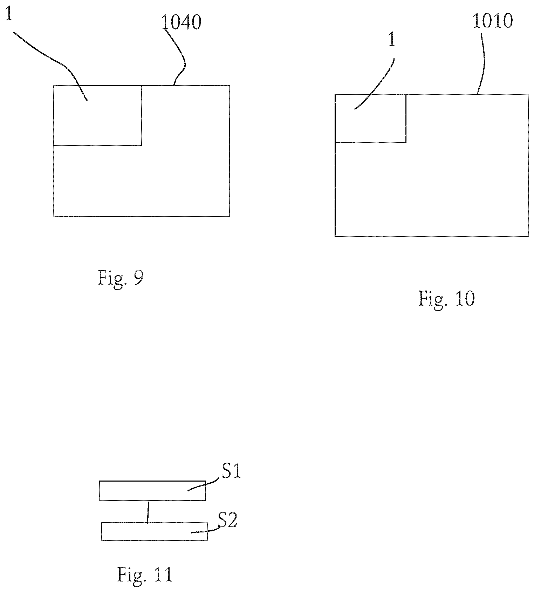

Both the electromagnetic fluctuations of the environment and the temperature can influence the width of the Josephson peaks. The inventors have found that the proximity of a Josephson peak to the zero-bias favors that energy adsorbed from the environment moves the correlated electrons from one side of the coupled Josephson junctions to the other side. The zero current point occurs at voltages biases amounting to some fraction of millielectronvolt. This voltage value can be seen as the voltage that will spontaneously be generated by the system in the absence of contacts to external electrodes. In other words, the system formed by the first superconducting element as a source S - a quantum dot as an island- and a second superconducting element as a drain is a micro-battery (figure 9).

Figure 10 shows a detector 1010 having a system 1, the detector being adapted for the detection of microwave radiation, with the gate electrode. The system 1 provides for two Josephson peaks. The width of the Josephson peaks and the width between the Josephson peaks is influenced by electromagnetic fluctuations of the environment.

Therefore, when the detector 1010 receives external microwave radiation, the distance between the Josephson peaks of the coupled Josephson junctions consequently widens and the current at zero bias increases. For temperatures in the millikelvin range and appropriate circuit design it is possible to narrow down the split Josephson peaks to a few microelectronvolts. This enhances the resolution of microwave detection.

The skilled person understands that the detector 1010 can detect photons of very low energy, surpassing current Kinetic Impedance Detectors, which are normally used in Cosmology.

Furthermore, by shifting the Josephson peaks from zero-bias by the gate potential V_{g} and detecting the variation of the zero-bias anomalous current, it is possible to perform spectroscopic measurement of low energy radiation.

The detector 1010 therefore has a detection bandwidth which can be tuned with an electrostatic potential applied to the island.

Fig. 11 shows a method of generating directional Cooper pair current. The method comprises providing a superconducting system as detailed above (step S1), in which an asymmetry can be induced, and activating the Coulomb effect and generating a directional Cooper pair current (S2). An electrostatic potential can be applied to the quantum dot or superconducting island, to activate, deactivate or reverse the direction of the Cooper pair current.

In summary, the present invention proposes a system comprising double coupled Josephson junction for generating two Josephson peaks whose width and positions can be tuned. Broader peaks enable generating higher zero-bias anomalous currents, whereas narrow peaks enable improving the detection sensitivity of a radiofrequency detector having such a double coupled Josephson junction. The width can be controlled to a certain degree with the design of the circuit.

Such a system can be used for directing the control currents of a superconducting qubit, detection of radiofrequency for space detection of ultra-low energy radiation.

The foregoing description of the preferred embodiments of the disclosure has been presented for purposes of illustration and description. It is not intended to be exhaustive or to limit the invention to the precise form disclosed, and modifications and variations are possible in light of the above teachings or may be acquired from practice of the invention. The embodiment was chosen and described in order to explain the principles of the invention and its practical application to enable one skilled in the art to utilize the invention in various embodiments as are suited to the particular use contemplated. It is intended that the scope of the invention be defined by the claims appended hereto and their equivalents.

### List of reference numbers

System 1
First Josephson junction 12
Second Josephson junction 14
Current peaks P 1, P2
first superconducting element 20
quantum dot or small superconducting 22
second superconducting element 26
gate device 30
detector 1010
generator 1040

## Claims

1. Superconducting system (1),
the system comprising a nanoscopic element or quantum dot (22) embedded between a first superconducting element (20) and a second superconducting element (26), to form a first Josephson junction (12) and a second Josephson junction (14) for quantum tunnelling of Cooper pairs through them,
wherein the first Josephson junction comprises the first superconducting element (20) and the quantum dot (22),
the second Josephson junction comprises the quantum dot (22) and the second superconducting element (26),
wherein the quantum dot (22) is a superconductor or a non-superconductor with proximitized superconductivity induced by quantum tunnelling of Cooper pairs or by Andreev reflections, and
wherein the nanoscopic element or quantum dot (22) has a size in a size range in which Coulomb effects are present.

2. Superconducting system according to claim 1, wherein the nanoscopic element or quantum dot (22) is smaller than 10000 nm³, in particular is a nanoscopic element with an area smaller than 400 nm2 and a height of less than 20 nm.

3. Superconducting system according to claim 1 or 2, wherein the first and second superconducting elements (20, 26) have a mesoscopic or macroscopic dimensions.

4. System according to any of claims 1 to 3, wherein the first Josephson junction (12) has a first capacitance, the second Josephson junction (13) has a second capacitance (C2), and wherein the capacitances (C1, C2) of the two Josephson junctions (12, 14) are typically less than 1 femtofarad.

5. System according to claim 4, wherein the system is adapted to generate two Josephson peaks separated by an energy spacing of variable width, each Josephson peak representing the quantum tunnelling of Cooper pairs, wherein the variable width of the spacing depends on the size of the nanoscopic element or quantum dot (22) and the first and second capacitances (C1, C2).

6. System according to claim 5, wherein the nanoscopic element or quantum dot (22) is separated from the first and second superconducting elements (20, 26) by a first and second low-conductance layers (24, 28), the first and second low-conductance layers (24, 28) being weak electronic links, and wherein the variable width of the spacing further affects the conductance of the first and second low-conductance layers (24, 28).

7. System according to any one of claims 1 to 6, wherein an electrostatic gate device (30) is coupled to the nanoscopic element or quantum dot (22), to modify the electrostatic potential of the nanoscopic element or quantum dot (22), thereby modifying the spectral position of the two Josephson peaks.

8. System according to claim 7, wherein the electrostatic gate device (30) is a gate electrode coupled to the nanoscopic element or quantum dot (22), the electrostatic gate device being adapted to apply a gate Voltage (V_{g}) to the nanoscopic element or quantum dot (22).

9. System according to claim 8, wherein the gate electrode is separated from the nanoscopic element or quantum dot (22) by an insulating material.

10. Superconducting diode having a source and drain, comprising a system according to claim 1 to 9, wherein the first superconducting element (20) is a current source, and the second superconducting element (26) is a drain.

11. Superconducting diode according to the preceding claim, wherein the superconducting diode is tunable, wherein a gate electrode is connected to the nanoscopic element or quantum dot (22) to tune the behavior of the superconducting diode by changing the electrostatic potential of the nanoscopic element or quantum dot (22).

12. Detector having a system according to any of claims 1 to 9 for microwave detection.

13. Generator of dc Cooper pair currents at zero voltage bias applied between a source electrode and a drain electrode having a system according to any of claims 1 to 9.

14. Method of generating directional Cooper pair current, comprising
providing a superconducting system,
the system comprising a nanoscopic element or quantum dot (22) embedded between a first superconducting element (20) and a second superconducting element (26), to form a first Josephson junction (12) and a second Josephson junction (14) for quantum tunnelling of Cooper pairs through them,
wherein the first Josephson junction comprises the first superconducting element (20) and the quantum dot (22),
the second Josephson junction comprises the quantum dot (22) and of the second superconducting element (26),
wherein the quantum dot (22) is a superconductor or a non-superconductor with proximitized superconductivity induced by quantum tunnelling of Cooper pairs or by Andreev reflections, and
wherein the nanoscopic element or quantum dot (22) has a size in a size range in which Coulomb effects is present,
and activating the Coulomb effect to generate a dc Cooper pair current.

15. Method according to claim 14, comprising applying an electrostatic potential to the nanoscopic element or quantum dot (22), to activate, deactivate or reverse the direction of the dc Cooper pair current.
